# FASCICULE DE BREVET EUROPEEN

(11) **EP 2 177 957 B1**
(45) Date de publication et mention de la délivrance du brevet: **14.08.2013**
(21) Numéro de dépôt: 10152831.3
(22) Date de dépôt: 01.05.2006
(51) Int. Cl.: G04B 19/04, G04D 3/00, G04B 45/02, B81C 1/00

(54) **Organe d'affichage analogique en matériau cristallin**
Analoger Anzeiger aus kristallenem Material
Analogue indicating organ in crystalline material

(30) Priorité: 12.05.2005 EP 05103979
(43) Date de publication de la demande: 21.04.2010
(62) Demande divisionnaire de: 06754937.8
(73) Titulaire: Montres Breguet SA, 1344 L'Abbaye (CH)
(72) Inventeur: Meister, Pierre-André, 2502, Bienne (CH); Zanetta, André, 2075 Wavre (CH); Fleury, Emmanuel, 2740, Moutier (CH); Blondeau, Fabien, 2054, Chézard St-Martin (CH)
(74) Mandataire: Couillard, Yann Luc Raymond

(56) Documents cités:
- EP-A- 0 732 635
- DE-U- 7 432 697
- FR-A7- 2 117 486
- PATENT ABSTRACTS OF JAPAN vol. 011, no. 93 (P-559), 24 mars 1987 (1987-03-24) -& JP 61, 245078, A, (CITIZEN WATCH CO LTD), 31 octobre 1986 (1986-10-31)

## Description

L'invention concerne un organe d'affichage analogique tel qu'une aiguille de pièce d'horlogerie.

L'invention concerne aussi une pièce d'horlogerie et un procédé de fabrication d'un organe d'affichage.

La fabrication d'une aiguille destinée à être utilisée comme organe d'affichage dans une pièce d'horlogerie est particulièrement complexe, en particulier lorsqu'il s'agit d'une aiguille destinée à équiper une pièce d'horlogerie haut de gamme, pour laquelle l'aiguille doit présenter un aspect de surface particulièrement soigné, éventuellement muni de facettes. Un exemple d'aiguille en pierre revêtue de métal est divulgué dans le document JP 61-245078.

Actuellement, les aiguilles sont fabriquées en laiton, en acier, en or, en aluminium, ou en alliage spécial. Elles peuvent être traitées galvaniquement, recouvertes de peinture, oxydées, ou brutes lorsque le matériau utilisé est l'or. Elles sont généralement réalisées par usinage ou par estampage.

Toutefois, les techniques d'usinage et d'estampage de ces matériaux ne permettent pas toujours d'obtenir une précision dimensionnelle satisfaisante, ce qui nécessite des opérations supplémentaires d'ébavurage, de polissage, etc. pour obtenir la forme finale de l'aiguille.

De plus, il est généralement nécessaire d'appliquer sur les aiguilles de multiples traitements pour garantir des états de surface de bonne qualité.

Par ailleurs, les techniques actuelles de fabrication des aiguilles ne permettent pas de réaliser toutes les formes souhaitées, de sorte que la créativité des concepteurs de pièces d'horlogerie s'en trouve bridée.

La présente invention vise à proposer une aiguille qui soit plus facile à fabriquer tout en offrant une grande liberté de conception de sa forme, et qui puisse être fabriquée en série de manière à minimiser les coûts de production.

Dans ce but, l'invention propose un organe d'affichage analogique équipant une pièce d'horlogerie, du type comportant un corps principal dans lequel est aménagé un trou d'axe, le trou d'axe étant ajusté sur un axe d'entraînement, le corps principal étant réalisé en matériau cristallin, le corps principal de l'organe d'affichage analogique ayant la forme d'une aiguille horlogère et comportant une portion proximale, dans laquelle est aménagé le trou d'axe, et une portion distale qui constitue le tronçon indicateur de l'aiguille, caractérisé en ce que ledit matériau cristallin est à base de silicium et en ce que la portion distale est liée à la portion proximale par au moins une poutre dont la largeur, dans un plan transversal à l'axe, est comprise entre trente et deux cent microns.

L'organe d'affichage selon l'invention présente l'avantage de pouvoir être facilement fabriqué en utilisant des technologies éprouvées dans la microélectronique pour la fabrication de circuits intégrés et dans la micromécanique pour la fabrication de micro-structures.

Le silicium présente l'avantage d'être très léger, puisque sa masse volumique est d'environ 2,49 kg/dm3, ce qui permet de minimiser la masse de l'organe d'affichage, donc les problèmes d'inertie et de balourd, en particulier lorsqu'il a la forme d'une aiguille. De plus, la réduction du balourd et de l'inertie de l'organe d'affichage a une influence favorable sur le dimensionnement des moyens d'entraînement de l'organe d'affichage et sur la consommation énergétique de ces moyens d'entraînement.

Selon d'autres caractéristiques de l'invention :
- la portion distale est liée à la portion proximale par deux poutres dont chaque largeur, dans un plan transversal à l'axe, est égale à cinquante microns;
- la portion distale a la forme d'un triangle ;
- chaque poutre comporte des évidements agencés pour alléger l'organe d'affichage sans pénaliser sa rigidité et sa résistance aux chocs ;
- les évidements forment des ouvertures qui sont alignées et réparties sur la longueur de chaque poutre en définissant des ponts de matière entre les deux parties parallèles formant chaque poutre ;
- le corps principal comporte, dans son épaisseur, une multitude de perçages qui sont parallèles à l'axe d'entraînement et qui ont un diamètre inférieur à cinquante microns;
- la surface supérieure du corps principal comporte des motifs en relief ;
- la surface supérieure du corps principal comporte des facettes ;
- au moins une face du corps principal est pourvue d'un revêtement réalisé dans un matériau différent du corps principal ;
- le revêtement est réalisé en métal ;
- le matériau cristallin est du silicium monocristallin.

L'invention propose aussi une pièce d'horlogerie caractérisée en ce qu'elle comporte au moins un organe d'affichage analogique selon l'une des caractéristiques précédentes.

D'autres caractéristiques et avantages de la présente invention apparaîtront plus clairement à la lecture de la description détaillée qui suit, faite en référence aux dessins annexés donnés à titre d'exemple non limitatifs et dans lesquels :
- les figures 1 à 6 sont des vues en section verticale qui illustrent schématiquement plusieurs étapes d'un procédé de fabrication d'aiguilles de pièces d'horlogerie à partir d'une plaque de silicium conformément aux enseignements de l'invention ;
- les figures 7a et 7b qui ne font pas parties de l'invention sont des vues de dessus qui représentent schématiquement la plaque de silicium à l'étape illustrée par la figure 6 ;
- la figure 8 qui ne fait pas partie de l'invention est une vue de dessus qui représente schématiquement une montre équipée d'au moins une aiguille obtenue par le procédé selon l'invention ;
- la figure 9 qui ne fait pas partie de l'invention est une vue en coupe verticale qui représente schématiquement une aiguille obtenue par le procédé selon l'invention ;
- la figure 10 qui ne fait pas partie de l'invention est une vue de dessus qui représente schématiquement une aiguille obtenue par le procédé selon l'invention et munie de deux facettes longitudinales ;
- la figure 11 qui ne fait pas partie de l'invention est une vue en coupe verticale selon le plan de coupe 11-11 de l'aiguille de la figure 10;
- la figure 12 est une vue de dessus qui représente schématiquement une aiguille obtenue par le procédé selon l'invention et munie de deux poutres de liaison;
- la figure 13 est une vue agrandie d'un tronçon de poutre de la figure 12;
- la figure 14 est une vue en coupe axiale selon le plan 14-14 qui représente de manière agrandie la portion d'extrémité distale de l'aiguille de la figure 12.

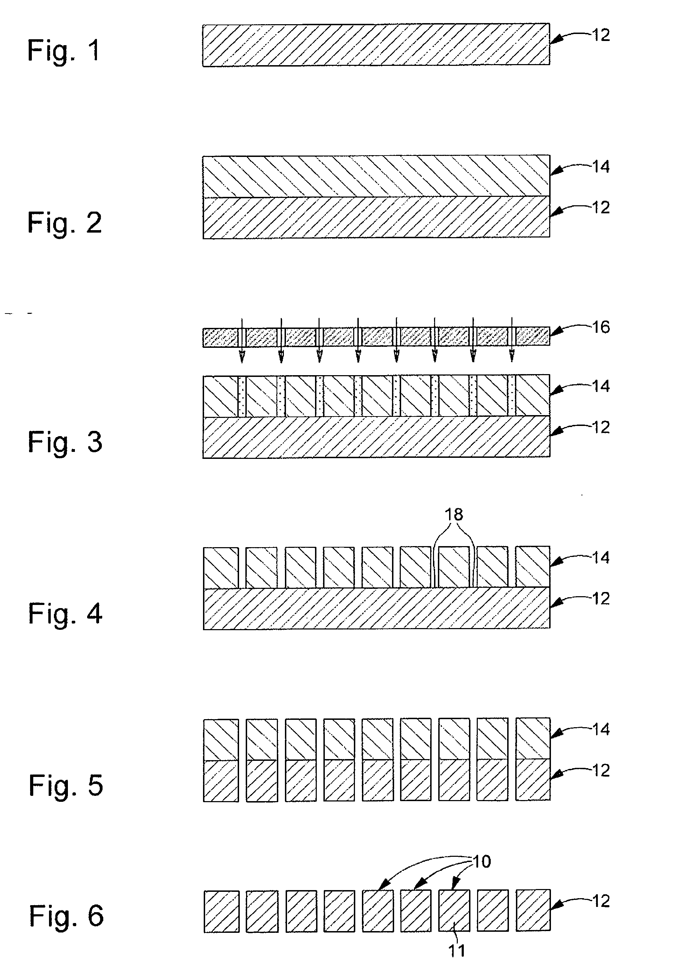

Sur les figures 1 à 7, on a représenté plusieurs étapes d'un procédé pour la fabrication d'organes d'affichage analogique 10 conforme aux enseignements de l'invention.

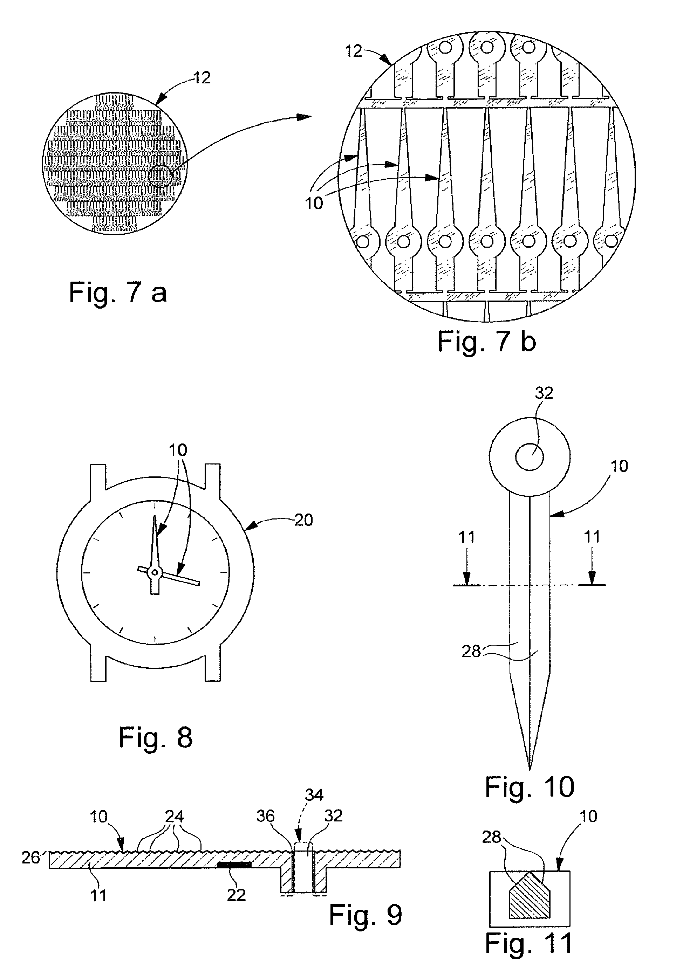

Les organes d'affichage analogique 10 sont ici des aiguilles 10, dont un exemple est représenté schématiquement sur la figure 9.

Conformément aux enseignements de l'invention, chaque aiguille 10 comporte un corps principal 11 qui est réalisé en matériau cristallin à base de silicium.

On entend ici par matériau cristallin à base de silicium un matériau cristallin contenant du silicium tel que le silicium monocristallin, le silicium polycristallin, et le quartz.

De préférence, l'aiguille 10 selon l'invention est micro-usinée dans une plaque de silicium 12 monocristallin telle que celles qui sont utilisées pour la réalisation de circuits électroniques intégrés, ces plaques étant désignées généralement sous le terme de « wafer ».

Avantageusement, une série de plusieurs aiguilles 10 est réalisée dans une même plaque de silicium 12, selon une méthode dite de « batch processing », en faisant appel à des technologies issues du domaine de la microélectronique qui permettent de fabriquer des microstructures mécaniques dans une plaque de silicium 12.

Ces technologies sont déjà mises en oeuvre pour la fabrication de capteurs de pression, d'accéléromètres, de micro-activateurs, de micro-pompes. Elles comportent principalement deux types de procédés de fabrication qui sont les procédés de gravage à sec dits « dry etching », et les procédés de gravage humide dits « wet etching ».

Ces procédés utilisent généralement des techniques de masquage qui permettent d'éliminer localement une couche de matériau d'épaisseur déterminée.

Des procédés de gravage à sec utilisent, par exemple, un faisceau laser ou une source de plasma à haute densité.

Selon un mode de réalisation préféré de l'invention, on utilise des technologies qui permettent de micro-usiner la plaque de silicium 12, de manière à réaliser les aiguilles 10 directement dans l'épaisseur de la plaque de silicium.

L'électropolissage est un exemple de technique utilisée pour le gravage du silicium. Cette technique utilise la propriété pour le silicium monocristallin d'être porosifié par gravage électrochimique anodique dans une solution d'acide fluorhydrique en utilisant une faible densité de courant, cette technique permettant d'éliminer complètement le silicium avec des densités de courant élevées.

Un exemple de mise en oeuvre de la technique d'électropolissage du silicium est décrit dans la publication intitulée "Electrochemical Fabrication of Multiwalled Micro Channels" de R.W. Tjerkstra et al, pages 133-136 des "Proceedings of Micro Total Analysis Systems 98 Workshop", Banff, Canada, dans le cadre de la fabrication de microcanaux coaxiaux dont les parois de séparation sont réalisées en silicium poreux. On pourra se reporter à cette publication, incorporée ici par référence, pour plus de précisions sur ce procédé.

D'autres exemples de procédés de micro-usinage du silicium sont décrits dans l'ouvrage intitulé « Fundamentals of microfabrication », de Marc Madou, édité par CRC Press, et portant la référence ISBN 0-8493-9451-1, incorporé ici par référence, auquel on pourra se reporter pour plus de détails.

On décrit maintenant de manière simplifiée les principales étapes du procédé selon l'invention.

Sur la figure 1, on a représenté une plaque de silicium 12 avant la mise en oeuvre du procédé selon l'invention.

La figure 2 illustre une étape de dépôt d'une couche sacrificielle 14 sur la face supérieure de la plaque de silicium 12.

La figure 3 illustre le traitement de la couche sacrificielle 14, à travers un masque 16, visant à modifier localement la structure de la couche sacrificielle 14 de manière à dessiner sur la plaque de silicium 12 un motif représentant une série d'aiguilles 10.

Sur la figure 4, la couche sacrificielle 14 est développée, c'est-à-dire que les portions de couche sacrificielle 14 traitées ont été éliminées, de sorte que la couche sacrificielle 14 laisse apparaître localement des portions 18 de la face supérieure de la plaque de silicium 12.

Sur la figure 5, la plaque de silicium 12 a été gravée à travers la couche sacrificielle, de préférence selon une technique de gravage anisotrope, de sorte que le motif représentant les aiguilles 10 est maintenant dessiné dans l'épaisseur de la plaque de silicium 12.

La couche sacrificielle 14 restante est alors éliminée, comme représentée sur la figure 6.

On obtient alors une plaque de silicium 12 dans laquelle les aiguilles 10 sont prédécoupées et retenues attachées au corps de la plaque 12 par des ponts de matière, comme on l'a représenté sur les figures 7a et 7b.

L'étape finale de la fabrication des aiguilles 10 consiste à détacher les aiguilles de la plaque de silicium 12.

Avantageusement, le procédé selon l'invention peut comporter au moins une étape au cours de laquelle un revêtement, par exemple métallique, est déposé sur le silicium formant les aiguilles 10. Ce revêtement peut-être déposé selon des techniques de dépôt chimique ou physique en phase vapeur (« Chemical Vapour Déposition » ou « Physical Vapour Déposition »).

Le procédé selon l'invention peut aussi comporter une étape de traitement chimique et/ou thermique appliqué sur la surface du silicium formant les aiguilles 10, par exemple en vue de modifier l'aspect de surface du silicium.

On note que des étapes de gravage peuvent aussi être mises en oeuvre de manière à modifier l'aspect de surface du silicium, ou de manière à modifier l'aspect de surface d'un revêtement déposé sur le silicium, en réalisant des motifs géométriques ou autres, ce qui permet d'obtenir des effets optiques intéressants. De tels motifs géométriques peuvent, par exemple, donner un aspect de type guillochage à la surface des aiguilles 10 réalisées dans le silicium. De telles étapes de gravage peuvent être mises en oeuvre lorsque les aiguilles 10 sont encore portées par la plaque de silicium 12.

Selon l'exemple représenté sur la figure 9, la face supérieure de l'aiguille 10 est pourvue de motifs géométriques 24 en relief qui ont été réalisés par gravage du silicium. Un dépôt métallique 26 a été réalisé sur ces motifs géométriques 24 ce qui donne à l'aiguille 10 un aspect extérieur métallique guilloché. On note qu'un tel résultat serait très difficile à obtenir dans le cas d'une aiguille 10 dont le corps principal 11 est en métal.

Selon l'exemple représenté sur les figures 10 et 11, on a réalisé par gravage deux facettes 28 longitudinales dans la face supérieure de l'aiguille 10.

Selon des variantes de réalisation, les motifs 24 et les facettes 28 peuvent posséder des profils incurvés de manière à former des ondulations sur la surface de l'aiguille 10.

On note que le procédé de fabrication d'aiguilles 10 selon l'invention permet de réaliser facilement des aiguilles 10 ayant des formes et des aspects extérieurs très variés.

Avantageusement, le procédé selon l'invention peut être mis en oeuvre en parallèle sur plusieurs plaques de silicium 12, de manière à réaliser simultanément, dans plusieurs plaques de silicium 12, des aiguilles 10 de caractéristiques similaires.

Sur la figure 8, on a représenté une montre 20 qui est pourvue d'au moins une aiguille 10 en silicium.

Chaque aiguille 10 est prévue pour être liée en rotation à un axe ou une roue du mouvement horloger (non représenté) de la montre 20. A cet effet, l'aiguille 10 est pourvue ici d'un trou d'axe 32 destiné à être chassé sur un axe d'entraînement 34.

Avantageusement, la surface axiale interne du trou d'axe 32 est pourvue d'une couche 36 de matériau destinée à permettre le chassage de l'aiguille 10 par déformation de la couche 36 ou par glissement contre la couche 36, en limitant les risques de rupture du corps principal 11.

Selon une variante de réalisation, l'aiguille 10 selon l'invention peut être collée ou soudée sur l'axe d'entraînement 34.

Selon un autre exemple, qui est représenté sur la figure 9, un élément 22 de circuit intégré est réalisé dans l'épaisseur de la plaque 12 de silicium, dans le corps 11 de l'aiguille 10.

L'élément 22 de circuit intégré peut être réalisé, selon les technologies de fabrication classiques de la microélectronique, avant, pendant, ou après la mise en oeuvre du procédé de fabrication selon l'invention. Ainsi, des éléments 22 de circuit intégré peuvent être préalablement réalisés dans la plaque de silicium 12 telle que représentée sur la figure 1, à partir de laquelle les aiguilles 10 sont fabriquées.

L'élément 22 de circuit intégré peut être raccordé électriquement au circuit de commande de la montre 20, à travers l'arbre de rotation de l'aiguille 10.

L'élément 22 de circuit intégré comporte, par exemple, une diode électroluminescente intégrée dans l'épaisseur de l'aiguille 10. L'aiguille 10 peut ainsi être éclairée par l'intérieur, en exploitant les propriétés de transparence du silicium.

L'élément 22 de circuit intégré peut comporter un capteur prévu pour fournir au circuit de commande de la montre 20 des indications sur la position angulaire de l'aiguille 10 par rapport au cadran.

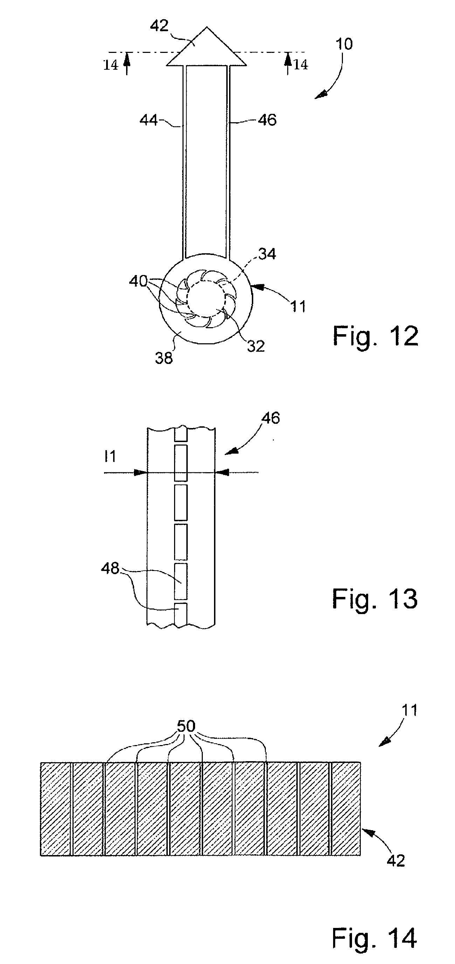

Sur les figures 12 à 14, on a représenté un mode de réalisation perfectionné selon l'invention dans lequel l'aiguille 10 est réalisée entièrement en silicium, c'est-à-dire que son corps principal 11, qui forme la structure mécanique de l'aiguille 10, est en silicium et définit la forme extérieure de l'aiguille 10. Bien entendu, le corps principal 11 peut être recouvert d'une ou plusieurs couches de revêtements tels que des revêtements métalliques.

Selon le mode de réalisation représenté, le corps principal 11 comporte une portion proximale 38 annulaire dans laquelle est aménagé le trou d'axe 32 devant permettre le montage de l'aiguille 10 sur l'axe d'entraînement 34 de la montre 20. Le trou d'axe 32 est prévu pour être ajusté sur l'axe d'entraînement 34, de manière que la fixation de l'aiguille 10 sur l'axe d'entraînement 34 soit similaire à un chassage.

Le trou d'axe 32 est ici pourvu d'éléments flexibles 40 en forme de languettes qui sont réalisés d'une seule pièce avec la portion proximale 38 du corps principal 11 et qui sont en saillie sur la surface interne du trou d'axe 32. Les éléments flexibles 40 sont prévus pour se déformer élastiquement lors du montage de l'aiguille 10 sur l'axe d'entraînement 34. Ainsi, après montage, les éléments flexibles 40 exercent une force de serrage sur l'axe d'entraînement 34 qui permet de retenir axialement l'aiguille 10 sur l'axe d'entraînement 34 et de lier en rotation ces deux éléments.

Les éléments flexibles 40 sont formés de préférence au cours de l'étape de micro-usinage de la plaque 12 de silicium.

Le corps principal 11 comporte aussi une portion distale 42 qui constitue le tronçon indicateur de l'aiguille 10. La portion distale 42 a ici la forme d'un triangle mais elle pourrait prendre toute autre forme adéquate en vue d'indiquer une position angulaire déterminée sur le cadran de la pièce d'horlogerie 20.

La portion distale 42 est liée à la portion proximale 38 par deux poutres 44, 46 dont la largeur 11, dans un plan transversal à l'axe d'entraînement 34, est comprise entre trente et deux cent microns, et est de préférence égale à cinquante microns. La largeur 11 de cinquante microns offre un bon compromis entre la rigidité et la finesse de la poutre 44, 46.

On obtient ainsi une aiguille 10 dont pratiquement seules la portion proximale 38 et la portion distale 42 sont visibles, lorsque l'utilisateur de la montre 20 consulte les indications donnée par l'aiguille 10, en particulier en vue de dessus. En effet, combinée avec l'épaisseur très faible, comprise par exemple entre trente et cent microns, de préférence égale à cinquante microns, la faible largeur 11 permet de rendre les poutres 44, 46 quasiment invisibles à l'oeil nu et ainsi de rendre mieux visibles les éléments situés sous l'aiguille 10, entre la portion proximale 38 et la portion distale 42, notamment des éléments affichés sur le cadran de la montre 20. De plus, l'utilisation de ces poutres 44, 46 quasiment invisibles permet d'offrir plus de liberté dans le dessin de l'aiguille 10, en dissimulant une partie de la structure de l'aiguille 10.

Bien entendu, l'aiguille 10 selon l'invention peut comporter plus de deux poutres 44, 46. Le nombre de poutres 44, 46 pourra être choisi en fonction de la forme de l'aiguille 10, notamment en fonction de la forme de la portion distale 42, en vue d'assurer une rigidité et une résistance aux chocs suffisante de l'aiguille 10.

Sur la figure 13, qui est une vue agrandie d'une poutre 46 de la figure 12, on constate que les poutres 46 peuvent être munis d'évidements 48 qui sont agencés de manière adaptée pour alléger la structure de l'aiguille 10 sans significativement pénaliser sa rigidité et sa résistance aux chocs. Les évidements 48 sont constitués ici par des ouvertures ou fenêtres qui sont alignées et réparties sur la longueur de la poutre 46 en définissant des ponts de matière entre les deux parties parallèles formant la poutre 46.

De manière avantageuse, comme on peut le voir sur la figure 14, le corps principal 11 de l'aiguille 10 comporte, dans son épaisseur axiale, une multitude de perçages 50 globalement cylindriques qui sont sensiblement parallèles à l'axe d'entraînement 34 et qui ont un diamètre inférieur à cinquante microns, de préférence un diamètre compris entre trois et dix microns. Le but de ces perçages 50 est de diminuer le balourd et l'inertie de l'aiguille 10. Comme la masse des poutres n'a que peu d'influence sur le balourd et l'inertie de l'aiguille 10, les perçages 50 sont agencés de préférence uniquement dans la portion distale 42, mais ils pourraient aussi être agencés dans les autres parties du corps principal 11.
Les perçages 50 traversent ici l'épaisseur du corps principal 11 de part en part. Ils ont des dimensions suffisamment faibles pour être invisibles à l'oeil nu pour l'utilisateur de la montre 20, de sorte qu'ils ne pénalisent pas l'aspect esthétique de l'aiguille 10.

## Revendications

1. Organe d'affichage analogique (10) destiné à équiper une pièce d'horlogerie (20), du type comportant un corps principal (11) dans lequel est aménagé un trou d'axe (32) agencé pour être ajusté sur un axe d'entraînement (34), le corps principal (11) ayant la forme d'une aiguille (10) horlogère et étant réalisé en matériau cristallin, le corps principal (11) comportant une portion proximale (38), dans laquelle est aménagé le trou d'axe (32), et une portion distale (42) qui constitue le tronçon indicateur de l'aiguille (10), **caractérisé en ce que** ledit matériau cristallin est à base de silicium et **en ce que** la portion distale (42) est liée à la portion proximale (38) par au moins une poutre (44, 46) dont la largeur, dans un plan transversal à l'axe (34), est comprise entre trente et deux cents microns.

2. Organe selon la revendication précédente, **caractérisé en ce que** la portion distale (42) est liée à la portion proximale (38) par deux poutres (44, 46) dont chaque largeur, dans un plan transversal à l'axe (34), est égale à cinquante microns.

3. Organe selon la revendication 1 ou 2, **caractérisé en ce que** la portion distale (42) a la forme d'un triangle.

4. Organe selon l'une des revendications précédentes, **caractérisé en ce que** chaque poutre (44, 46) comporte des évidements (48) agencés pour alléger l'organe d'affichage (10) sans pénaliser sa rigidité et sa résistance aux chocs.

5. Organe selon la revendication précédente, **caractérisé en ce que** les évidements (48) forment des ouvertures qui sont alignées et réparties sur la longueur de chaque poutre (44, 46) en définissant des ponts de matière entre les deux parties parallèles formant chaque poutre (44, 46).

6. Organe d'affichage analogique (10) selon l'une quelconque des revendications précédentes, **caractérisée en ce que** le corps principal (11) comporte, dans son épaisseur, une multitude de perçages (50) qui sont parallèles à l'axe d'entraînement (34) et qui ont un diamètre inférieur à cinquante microns.

7. Organe d'affichage analogique (10) selon l'une quelconque des revendications précédentes, **caractérisé en ce que** la surface supérieure du corps principal (11) comporte des motifs (24) en reliefs.

8. Organe d'affichage analogique (10) selon l'une quelconque des revendications précédentes, **caractérisé en ce que** la surface supérieure du corps principal (11) comporte des facettes (28).

9. Organe d'affichage analogique (10) selon l'une quelconque des revendications précédentes, **caractérisé en ce qu'**au moins une face du corps principal (11) est pourvue d'un revêtement (26) réalisé dans un matériau différent du corps principal (11).

10. Organe d'affichage analogique (10) selon la revendication précédente, **caractérisé en ce que** le revêtement (26) est réalisé en métal.

11. Organe d'affichage analogique (10) selon l'une quelconque des revendications précédentes, **caractérisé en ce que** le matériau cristallin est du silicium monocristallin.

12. Pièce d'horlogerie (20) **caractérisée en ce qu'**elle comporte au moins un organe d'affichage analogique (10) conforme à l'une quelconque des revendications précédentes.

## Patentansprüche

1. Analoges Anzeigeorgan (10), das dazu bestimmt ist, ein Zeitmessgerät (20) auszurüsten, und das von dem Typ ist, der einen Hauptkörper (11) umfasst, in dem ein Wellenloch (32) ausgebildet ist, das vorgesehen ist, um auf einer Antriebswelle (34) aufgepasst zu werden, wobei der Hauptkörper (11) die Form eines Uhrzeigers (10) aufweist und aus einem kristallinen Werkstoff ausgeführt ist, wobei der Hauptkörper (11) einen proximalen Teil (38), in dem das Wellenloch (32) ausgebildet ist, und einen distalen Teil (42), der den Anzeigeabschnitt des Zeigers (10) bildet, aufweist, **dadurch gekennzeichnet, dass** der kristalline Werkstoff auf Silizium-Basis ist und dass der distale Teil (42) durch wenigstens einen Balken (44, 46), dessen Breite in einer quer zur Welle (34) stehenden Ebene zwischen dreissig und zweihundert Mikrometer liegt, mit dem proximalen Teil (38) verbunden ist.

2. Organ nach vorhergehendem Anspruch, **dadurch gekennzeichnet, dass** der distale Teil (42) durch zwei Balken (44, 46), deren jeweilige Breite in einer quer zur Welle (34) stehenden Ebene fünfzig Mikrometer beträgt, mit dem proximalen Teil (38) verbunden ist.

3. Organ nach Anspruch 1 oder 2, **dadurch gekennzeichnet, dass** der distale Teil (42) die Form eines Dreiecks aufweist.

4. Organ nach einem der vorhergehenden Ansprüche, **dadurch gekennzeichnet, dass** jeder Balken (44, 46) Aussparungen (48) aufweist, die vorgesehen sind, um das Anzeigeorgan (10) leichter zu machen, ohne seine Steifigkeit und seine Schlagfestigkeit zu beeinträchtigen.

5. Organ nach vorhergehendem Anspruch, **dadurch gekennzeichnet, dass** die Aussparungen (48) Öffnungen bilden, die in einer Reihe angeordnet sind und über die Länge jedes Balkens (44, 46) verteilt sind, wobei sie zwischen den beiden jeden Balken (44, 46) bildenden parallelen Stücken Werkstoffbrücken definieren.

6. Analoges Anzeigeorgan (10) nach einem der vorhergehenden Ansprüche, **dadurch gekennzeichnet, dass** der Hauptkörper (11) in seiner Dicke eine Vielzahl von Bohrungen (50) aufweist, die parallel zur Antriebswelle (34) stehen und die einen Durchmesser aufweisen, der kleiner ist als fünfzig Mikrometer.

7. Analoges Anzeigeorgan (10) nach einem der vorhergehenden Ansprüche, **dadurch gekennzeichnet, dass** die Oberseite des Hauptkörpers (11) erhabene Motive (24) umfasst.

8. Analoges Anzeigeorgan (10) nach einem der vorhergehenden Ansprüche, **dadurch gekennzeichnet, dass** die Oberseite des Hauptkörpers (11) Facetten (28) umfasst.

9. Analoges Anzeigeorgan (10) nach einem der vorhergehenden Ansprüche, **dadurch gekennzeichnet, dass** wenigstens eine Fläche des Hauptkörpers (11) mit einem Überzug (26) versehen ist, der aus einem Werkstoff ausgeführt ist, der sich vom Hauptkörper (11) unterscheidet.

10. Analoges Anzeigeorgan (10) nach vorhergehendem Anspruch, **dadurch gekennzeichnet, dass** der Überzug (26) aus Metall ausgeführt ist.

11. Analoges Anzeigeorgan (10) nach einem der vorhergehenden Ansprüche, **dadurch gekennzeichnet, dass** der kristalline Werkstoff monokristallines Silizium ist.

12. Zeitmessgerät (20), **dadurch gekennzeichnet, dass** es wenigstens ein analoges Anzeigeorgan (10) gemäss einem der vorhergehenden Ansprüche umfasst.

## Claims

1. Analogue display member (10) fitted to a timepiece (20), of the type including a main body (11) in which an arbour hole (32) is made, said arbour hole (32) being fitted to a drive arbour (34), the main body (11) has the shape of a timepiece hand (10) and is made of a crystalline material, the main body (11) includes a proximal portion (38), in which the arbour hole (32) is arranged, and a distal portion (42) which forms the indicator section of the hand (10), **characterised in that** said crystalline material is a silicon based material and **in that** the distal portion (42) is connected to the proximal portion (38) by at least one beam (44, 46) whose width, in a transverse plane to the arbour (34), is comprised between thirty and two hundred microns.

2. Analogue display member (10) according to preceding claim, **characterised in that** the distal portion (42) is connected to proximal portion (38) by two beams (44, 46) whose width, in a transverse plane to drive arbour (34), is equal to fifty microns.

3. Analogue display member (10) according to claim 1 or 2, **characterised in that** the distal portion (42) has the form of a triangle.

4. Analogue display member (10) according to any of preceding claims, **characterised in that** each beam (44, 46) is provided with recesses (48) arranged to lighten the structure of display member (10) without penalising its rigidity and shock resistance.

5. Analogue display member (10) according to preceding claim, **characterised in that** the recesses (48) form apertures or windows which are aligned and distributed over the length of each beam (44, 46) defining bridges of material between the two parallel parts forming each beam (44, 46).

6. Analogue display member (10) according to any of the preceding claims, **characterized in that** the main body (11) includes, in the thickness thereof, a multitude of bores (50) which are parallel to the drive arbour (34) and which have a diameter smaller than fifty microns.

7. Analogue display member (10) according to any of the preceding claims, **characterized in that** the top surface of the main body (11) includes embossed patterns (24).

8. Analogue display member (10) according to any of the preceding claims, **characterized in that** the top surface of the main body (11) includes facets (28).

9. Analogue display member (10) according to any of the preceding claims, **characterized in that** at least one face of the main body (11) is provided with a coating (26) made in a different material from the main body (11).

10. Analogue display member (10) according to the preceding claim, **characterized in that** the coating (26) is made of metal.

11. Analogue display member (10) according to any of the preceding claims, **characterized in that** the crystalline material is monocrystalline silicon.

12. Timepiece (20) **characterized in that** it includes at least one analogue display member (10) according to any of the preceding claims.
